# EUROPÄISCHE PATENTSCHRIFT

(11) **EP 0 934 686 B1**
(45) Veröffentlichungstag und Bekanntmachung des Hinweises auf die Patenterteilung: **31.05.2000**
(21) Anmeldenummer: 97947701.5
(22) Anmeldetag: 21.10.1997
(51) Int. Cl.: H05K 7/14, H02B 1/30, H05K 5/02, G03G 15/00

(54) **VORRICHTUNG ZUM HALTEN EINER EINGABEEINHEIT**
DEVICE FOR HOLDING AN INPUT UNIT
DISPOSITIF POUR MAINTENIR UNE UNITE PERIPHERIQUE D'ENTREE

(30) Priorität: 22.10.1996 DE 19643633
(43) Veröffentlichungstag der Anmeldung: 11.08.1999
(73) Patentinhaber: Océ Printing Systems GmbH, 85586 Poing (DE)
(72) Erfinder: BEISS, Max, D-85737 Ismaning (DE); DIETL, Joseph, D-82008 Unterhaching (DE)
(74) Vertreter: Schaumburg, Karl-Heinz
(86) Internationale Anmeldenummer: DE9702442
(87) Internationale Veröffentlichungsnummer: WO9818305

(56) Entgegenhaltungen:
- DE-U- 8 913 798
- GB-A- 2 133 222
- US-A- 4 718 740
- US-A- 5 388 032

## Beschreibung

Die Erfindung betrifft eine Vorrichtung zum Halten einer Eingabeeinheit zur Eingabe von Steuerdaten für ein elektrisches Gerät, insbesondere an einem Drucker oder Kopierer.

Bekannt sind Drucker und Kopierer, bei denen die Eingabeeinheit, z.B. eine Tastatur und gegebenenfalls eine zugehörige Anzeigeeinheit außen am Drucker angebracht ist. Über die Tastatur werden beim Störungsfreien Betrieb des Druckers bestimmte Betriebsarten ausgewählt. So kann z.B. die Anzahl zu druckender Blätter, das Druckformat oder eine bestimmte Druckart (Simplex, Duplex) gewählt werden. Tritt ein Störungsfall im Drucker auf, so werden über die Tastatur durch eine qualifizierte Bedienperson Steuerdaten eingeben, die zu einer Lokalisierung bzw. Beseitigung des Fehlers führen. Nachteilig ist, daß die Tastatur relativ ungeschützt ist, so daß auch ungewollte Eingaben erfolgen können, z.B. durch Abstützen von Bedienpersonen auf der Tastatur oder durch Ablegen von Gegenständen.

Es sind auch Tastaturen bekannt, die aus einer mechanischen Halterung im Drucker entnommen werden und in ein Verkleidungsblech des Geräts mit Halteelementen eingehängt werden. Dabei sind von einer Bedienperson jedoch eine Anzahl von Handgriffen vorzunehmen, welch die Bedienbarkeit des Druckers verschlechtern.

Aus der DE 43 31 110 A1 ist für einen Schaltschrank eine ausziehbare Haltevorrichtung bekannt. Aufgrund der geneigten Bauweise der gehaltenen Tastatur wird jedoch ein großer Bauraum im Schaltschrank benötigt. Dies trifft auch auf die im Gebrauchsmuster DE-U- 82 12 927 angesprochene auf einer Unterlage ausziehbare Tastatur einer Datenverarbeitungsanlage zu.

Aus der DE 31 03 481 C2 ist eine ausziehbare Tastatur bekannt, die jedoch entlang einer kurvenförmigen Bahn bewegt werden muß.

Im Gebrauchsmuster DE-U- 89 13 798 wird eine ausziehbare Tastatur erläutert, die außerhalb des Gerätes in eine Schräglage abgekippt wird. Der dazu erforderliche Führungsmechanismus hat eine instabile Lagerung der Tastatur in der Bedienposition zur Folge.

Aus der US-A-4,718,740 ist eine Vorrichtung zum Halten einer Eingabeeinheit bekannt, die eine Tastatur zur eingabe von Daten umfaßt. Die Vorrichtung ist zusammen mit einer Anzeigeeinheit um eine Schwenkachse schwenkbar. Die Vorrichtung kann aus einer vertikalen Ruheposition heruas in eine annähernd horizontale Betriebsposition verschwenkt werden.

Die US-A-5,388,032 und die GB-A-2,133,222 beschreiben eine ähnliche Vorrichtung, deren Eingabeeinheit mit einer Tastatur ausschließlich in einer horizontalen Ebene verschiebbar ist. In der Ruheposition ist die Eingabeeinheit gegebenenfalls zusammen mit einer Anzeigeeinheit in ein Gerät geschoben.

Es ist Aufgabe der Erfindung, eine Vorrichtung zum Halten einer Eingabeeinheit anzugeben, die in der Bedienposition zur Horizontalen geneigt ist und in der Ruheposition wenig Raum innerhalb des Geräts in Anspruch nimmt.

Diese Aufgabe wird durch eine Vorrichtung der eingangs genannten Art dadurch gelöst, daß sie mindestens ein an der Eingabeeinheit angeordnetes Führungselement hat, welches von einem am Gerät angeordneten Aufnahmeelement bewegbar aufgenommen ist. Dabei ist die Eingabeeinheit im wesentlichen in einer Ebene zwischen einer Ruheposition und einer Bedienposition bewegbar. In der Ruheposition ist die Eingabeeinheit innerhalb des Geräts gelagert und in der Bedienposition ist die Eingabeeinheit von außen betätigbar.

Die Erfindung beruht auf der Überlegung, daß einer Bedienperson des Druckers oder Kopierers die Eingabeeinheit nur dann zur Verfügung stehen soll, wenn die Bedienperson tatsächlich Steuerdaten eingeben möchte und/oder zur Eingabe von Steuerdaten berechtigt bzw. qualifiziert ist. Dabei darf jedoch für die Bedienperson in dem im Vergleich zur Gesamtbetriebszeit seltenen Fall, daß sie die Eingabeeinheit benötigt, kein großer Mehraufwand und damit in Verbindung stehender Zeitverlust entstehen. Bei der Erfindung ist deshalb an der Eingabeeinheit ein Führungselement angeordnet, welches eine Bewegung der Eingabeeinheit in einer Ebene zwischen der Ruheposition und der Bedienposition ermöglicht. Die Bedienperson kann somit unterstützt durch das Führungselement die Eingabeeinheit linear bewegen. Diese lineare Bewegung ist denkbar einfach, so daß sie von der Bedienperson auch mit einer hohen Geschwindigkeit ausgeführt werden kann. Die Eingabeeinheit muß somit nicht entlang einer kurvenförmigen Bahn geführt werden oder in eine vorgegebene Position eingehängt werden. Somit ermöglicht die Erfindung einen schnellen Zugriff auf die Eingabeeinheit.

In der Ruheposition ist die Eingabeeinheit bei der Erfindung innerhalb des Geräts gelagert, so daß ein zufälliges Betätigen durch eine Verkleidung des Geräts wirksam verhindert wird. Die Eingabeeinheit ist in der Ruheposition somit von außen kaum bzw. gar nicht sichtbar. Die Anzahl der sichtbaren Bedienelemente verringert sich, so daß sich die Bedienung des Geräts vereinfacht. In der Bedienposition ist bei der Erfindung dagegen die Eingabeeinheit frei von außen betätigbar, so daß die Bedienperson eine ergonomisch zweckmäßige Arbeitsfreiheit hat.

Bei der Erfindung ist das Aufnahmeelement zur Horizontalen geneigt angeordnet, so daß die Eingabeeinheit auch in der Bedienposition leicht geneigt ist. Die Neigung ist abhängig von der Höhe, in welcher die Eingabeeinheit angeordnet ist. Sie wird so gewählt, daß sich beim Eingeben der Steuerdaten für die Bedienperson eine ergonomische Arbeitsposition ergibt. Durch die Neigung des Aufnahmeelementes kann die Eingabeeinheit selbst flach und damit bauraumsparend ausgeführt werden.

In einem Ausführungsbeispiel der Erfindung ist das Führungselement in einem Randbereich der Eingabeeinheit angeordnet und ein zweites Führungselement ist an einem gegenüberliegenden Randbereich der Eingabeeinheit angeordnet. Das Halten der Eingabeeinheit ist mit Hilfe von zwei Führungselementen sehr stabil möglich, so daß Druckkräfte beim Eingeben der Steuerdaten gut kompensiert werden und die Eingabeeinheit beim Eingeben ruhig liegt.

In einem weiteren Ausführungsbeispiel der Erfindung ragt in der Bedienposition das dem Gerät abgewandte Ende des Führungselements über das dem Gerät abgewandte Ende des Aufnahmeelements hinaus. Durch diese Maßnahme läßt sich eine kompakte Bauweise der Haltevorrichtung erreichen, da dies nach Art eines Teleskopauszugs aus dem Gerät gezogen werden kann.

Wird in einem anderen Ausführungsbeispiel der Erfindung das Führungselement in der Bedienposition in seiner Lage durch ein Rastelement fixiert, so können auch Kräfte beim Eingeben der Steuerdaten in Bewegungsrichtung der Eingabeeinheit auftreten, ohne das diese ihre Position verändert. Wird die Eingabeeinheit auch in der Ruheposition fixiert, so wir eine selbsttätige Bewegung der Eingabeeinheit zum Beispiel durch Rüttelbewegungen des Geräts beim Betrieb oder durch Schwerkraft bei geneigter Montage der Eingabeeinheit verhindert. Ist das Rastelement am den Gerät zugewandten Endbereich des Führungselements angeordnet, so kann ein einziges Rastelement sowohl in der Bedienposition als auch in der Ruheposition verwendet werden. Ein mit dem Rastelement verbundener Hebel, der nahe der Eingabeeinheit endet, erleichtert die Betätigung des Rastelements.

Das Rastelement kann so ausführt werden, daß ein Rückstellelement, wie z.B. eine Feder, das Rastelement selbsttätig in eine Normalstellung stellt, die auch beim Fixieren des Führungselements eingenommen wird. Die Rückstellkraft kann zum Abbremsen der Eingabeeinheit beim Bewegen in die Ruheposition bzw. in die Arbeitsposition genutzt werden. Dazu befinden sich im Bewegungsbereich des Rastelement Schrägen auf welche das Rastelement kurz vor Erreichen der Ruheposition oder der Bedienposition der Eingabeeinheit aufläuft und aus seiner Normalstellung gedrückt wird, wobei es mit zunehmendem Abstand zur Normalposition eine zunehmende Bremskraft auf die Schrägen entwickelt, wodurch aufgrund der Verbindung von Rastelement und Eingabeeinheit auch die Bewegung der Eingabeeinheit abgebremst wird. Dieses Abbremsen der Eingabeeinheit führt zu einer Erhöhung der Haltbarkeit der Haltevorrichtung, da hohe mechanische Belastungen durch Aufprall beim Erreichen der Ruheposition oder der Bedienposition vermieden werden. Auch die Eingabeeinheit wird durch die Bremsvorrichtung beim Erreichen der Ruheposition oder der Bedienposition vor Erschütterungen geschützt, die zu einer Beschädigung der Eingabeeinheit führen. Als Bremsvorrichtung werden auch Anschlagkörper aus elastischem Material verwendet, die vorzugsweise an Anschlagflächen der Führungen angeordnet sind.

Wird am dem Gerät abgewandten Ende des Führungselements quer zur Bewegungsrichtung eine Auflagefläche angeordnet, so erhöht sich die Bedienbarkeit, da eine Bedienperson auf diese Auflagefläche ihre Handflächen bei der Eingabe der Steuerdaten abstützen kann. In einem Hohlraum unterhalb der Auflagefläche wird ein Betätigungselement zum Betätigen des Rastelement angeordnet, so daß die Bedienperson von unten in die Auflagefläche eingreift und die Eingabeeinheit ähnlich wie eine Schublade aus dem Gerät zieht. Das Betätigungselement verläuft zweckmäßig über die gesamte Breite der Eingabeeinheit, so daß der Zugriff trotz durch die Auflagefläche verhinderter Sicht auf das Betätigungselement sicher erfolgen kann.

Betätigungselement und Bremsvorrichtung sind in einem Ausführungsbeispiel der Erfindung so miteinander gekoppelt, daß die Bremsvorrichtung beim Betätigen des Betätigungselements freigeschaltet wird. Durch diese Maßnahme ist das Bewegen der Eingabeeinheit reibungsarm möglich. Solange die Eingabeeinheit von der Hand der Bedienperson geführt wird, bestimmt diese die Bewegungsgeschwindigkeit der Eingabeeinheit. Rutscht die Eingabeeinheit der Bedienperson aus der Hand oder wird sie losgelassen, so ist das Betätigungselement nicht mehr betätigt und die Bremsvorrichtung wirksam, wodurch ein Aufprallen der Tastatur beim Erreichen der Ruhe- oder Bedienposition verhindert ist.

Wird in Bewegungsrichtung der Eingabeeinheit in der Ruheposition eine Verschlußvorrichtung angeordnet, die ein Bewegen der Eingabeeinheit in die Bedienposition verhindert, so kann der Zugriff auf die Eingabeeinheit wirksam beschränkt werden. Als Verschlußvorrichtung wird neben Schlössern auch die nur mit einem Werkzeug zu lösende Verkleidung des Geräts verwendet, welche im Servicefall vom Servicepersonal ohnehin gelöst werden muß. Somit kann nur eine qualifizierte Person im Servicefall Steuerdaten über die Eingabeeinheit eingeben, so daß insbesondere Fehlbedienungen durch unqualifizierte Personen ausgeschlossen sind.

Im folgenden wird die Erfindung anhand eines Ausführungsbeispiel erläutert. Dabei zeigen:
- Figur 1: eine Draufsicht auf eine Haltevorrichtung zum Halten einer Tastatur,
- Figur 2: Schnittdarstellungen der Haltevorrichtung, und
- Figur 3: die Anordnung der Haltevorrichtung in einem Drucker.

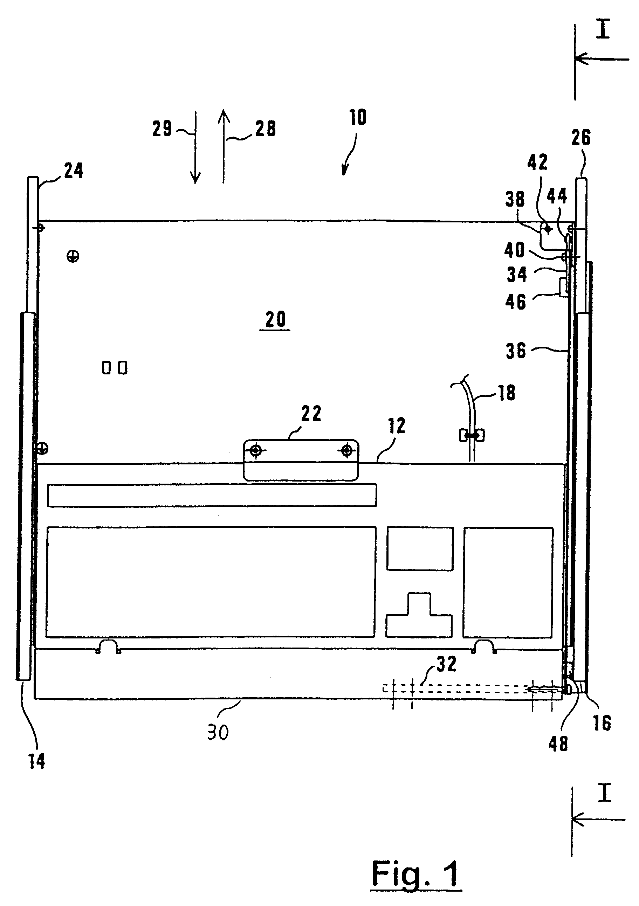

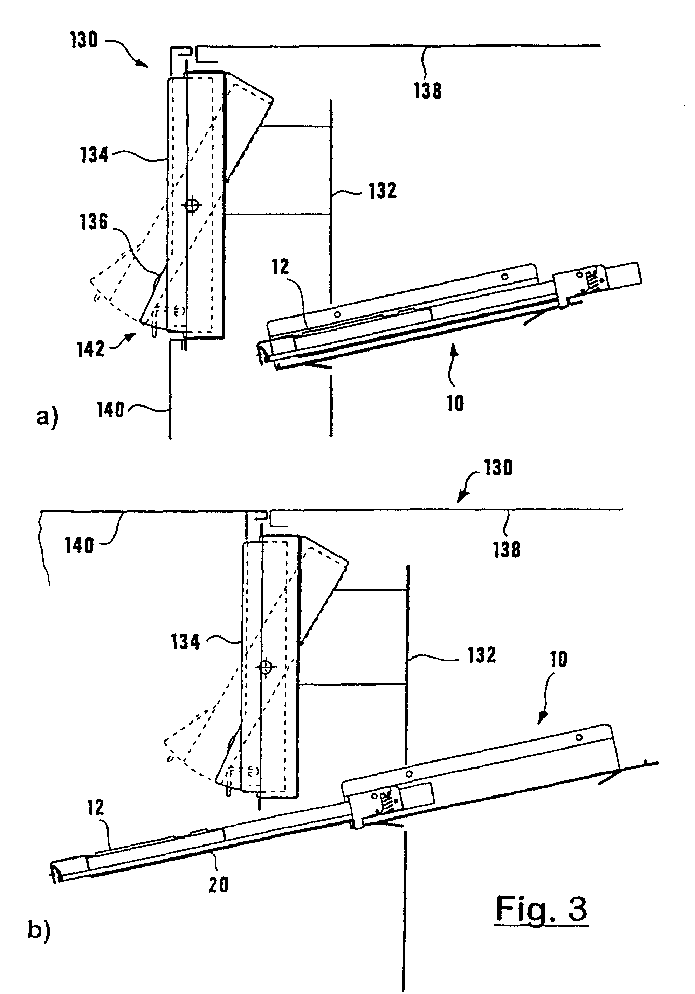

Figur 1 zeigt eine Draufsicht auf eine Haltevorrichtung 10 zum Halten einer Tastatur 12, z.B. einer bekannten Personalcomputer-Tastatur. Über die Tastatur 12 werden von einer Bedienperson Steuerdaten für einen Drucker (vgl. Figur 3) eingegeben, an dessen Rahmen zwei Führungsaufnahmen 14, 16 befestigt sind. Die Steuerdaten werden von der Tastatur 12 über eine Verbindungsleitung 18 zu einer zentralen Steuereinheit des Druckers übertragen. Die Tastatur 12 ist auf einer Grundplatte 20 mit Hilfe eines Befestigungsbleches 22 befestigt. Beidseitig der Tastatur 12 ist die Grundplatte 20 abgewinkelt, so daß zum einen ihre Biegesteifigkeit erhöht wird und zum anderen Befestigungsmöglichkeiten für Teleskopschienen 24 und 26 entstehen. Die Teleskopschiene 24 wird von der Führungsaufnahme 14 und die Teleskopschiene 26 von der Führungsaufnahme 16 umfaßt, so daß die Grundplatte 20 zusammen mit der Tastatur 12 in der durch die Grundplatte 20 festgelegten Ebene längs zu den Führungsaufnahmen 14, 16 bewegt werden kann, vgl. Pfeile 28 und 29.

In der Fig. 1 ist die Tastatur in einer Ruhestellung dargestellt, in welcher sich die Teleskopschienen 24 und 26 im wesentlichen innerhalb der Führungsaufnahmen 14 und 16 befinden. Wird die Tastatur in Richtung des Pfeiles 29 bewegt, so werden die Teleskopschienen 24 und 26 bis zum Erreichen einer Bedienposition durch die Führungsaufnahmen 14 und 16 geführt, bis sie fast mit ihrer gesamten Länge über die Führungsaufnahmen 14 und 16 hinausragen.

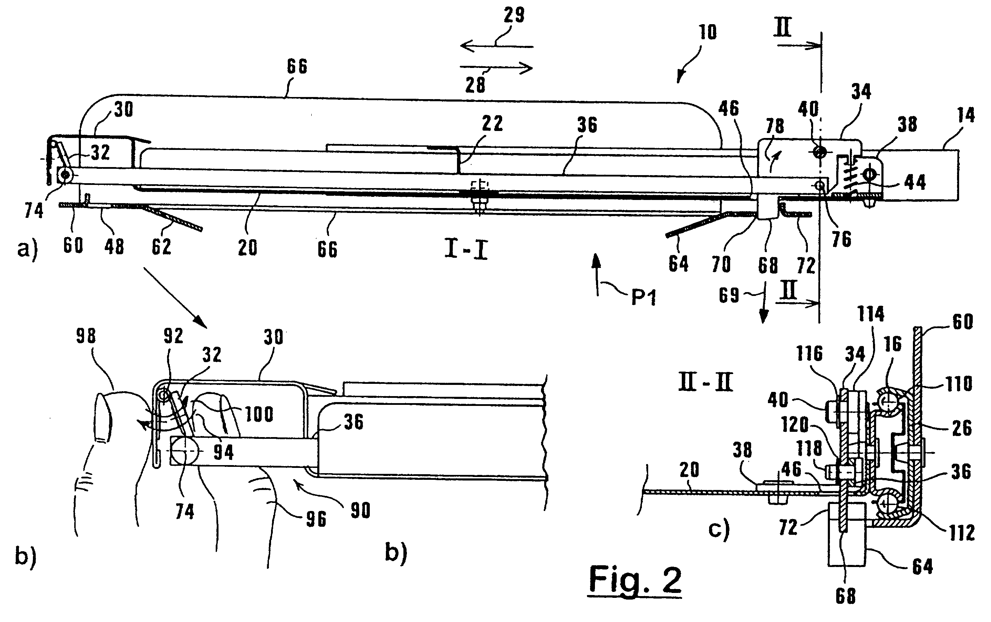

An der dem Drucker abgewandten Seite der Grundplatte 20 befindet sich eine Auflagefläche 30 zum Auflegen der Handflächen einer Bedienperson beim Eingeben der Steuerdaten. Unterhalb der Auflagefläche 30 befindet sich ein in der Fig. 1 nur angedeutetes Betätigungselement 32 zum Betätigen eines Rastelements 34 über einen Hebel 36. Die Wirkungsweise des Betätigungselements 32, des Rastelements 34 und des Hebels 36 wird unten an Hand der Fig. 2 erläutert. Das Rastelement 34 ist an einem Winkel 38 um eine Drehachse 40 drehbar gelagert. Der Winkel 38 ist über eine Hohlnietverbindung 42 mit der Grundplatte 20 verbunden. Am Winkel 38 ist außerdem eine Feder 44 befestigt, die das Rastelement 34 durch eine Aussparung 46 in der Grundplatte 20 drückt. In der Normalposition des Rastelements 34, d.h. ohne eine Betätigung des Betätigungselements 32 ist durch das Rastelement 34 in der Ruheposition die Grundplatte 20 und damit auch die Tastatur 12 an einem Blech 60 (vgl. Fig. 2) fixiert, d.h. ein selbsttätiges Bewegen bezüglich der Führungsaufnahmen 14 und 16 ist ausgeschlossen.

Eine weitere Aussparung 48 befindet sich an dem Drucker abgewandten Ende des Blechs 60 (vgl. Fig. 2). Die Aufnahme 48 nimmt das Rastelement 34 in der Bedienposition auf, so daß wiederum die Grundplatte 20 bezüglich der Führungsaufnahmen 14 und 16 und damit bezüglich des gesamten Druckers fixiert ist.

Fig. 2 zeigt in einem Teil a eine Schnittdarstellung der Haltevorrichtung 10 entlang des Schnitts I gemäß Fig. 1. Die Aussparung 48 befindet sich in einem winkelförmigen Blech 60, welches an der Führungsaufnahme 16 befestigt ist, wie unten an Hand eines Teils c der Fig. 2 erläutert. Vom Blech 60 stehen Schrägen 62 und 64 ab, die in entgegengesetzte Richtungen abfallen. Ein Blech 66 auf der anderen Seite der Haltevorrichtung 10 ist zwischen Führungsaufnahme 14 und Rahmen des Druckers befestigt, hat jedoch keine Aufnahmen und Schrägen. Sind in einem anderen Ausführungsbeispiel jedoch Rastelemente auf beiden Seiten der Grundplatte vorhanden, so wird auch das Blech 66 mit Schrägen und Aussparungen gefertigt.

Das Rastelement 34 hat einen Vorsprung 68, der durch die Feder 44 in Richtung eines Pfeils 69 gedrückt wird, so daß in der Ruheposition der durch die Aussparung 46 ragende Vorsprung zwischen einem Anschlagflächen 70 und 72 des Blechs 60 angeordnet ist, so daß bei einer Bewegung der Grundplatte 20 in Richtung des Pfeils 29 der Vorsprung 68 an die Anschlagfläche 70 und bei einer Bewegung in Richtung des Pfeils 28 an die Anschlagfläche 72 anstößt.

Das Rastelement 34 wird gelöst, indem das Betätigungselement 32 durch eine Bedienperson vom Drucker weg bewegt wird. Die Bewegung des Betätigungselements 32 wird über den Hebel 36 bis zum Rastelement 34 übertragen. Dazu ist der Hebel 36 an seinem einem Ende über ein Lager 74 mit dem Betätigungselement 32 und an seinem anderen Ende über ein Lager 76 mit dem Rastelement 34 verbunden. Wird das Betätigungselement 32 betätigt, so bewegt sich das Rastelement 34 in Richtung eines Pfeils 78, wodurch der Vorsprung 68 soweit angehoben wird, daß nunmehr eine Bewegung der Grundplatte 20 in Richtung des Pfeils 29 möglich ist. Der Vorsprung 68 stößt somit nicht mehr an die Anschlagsfläche 70 an, wenn die Grundplatte 20 in die Bedienposition gezogen wird. In der Bedienposition rastet der Vorsprung 68 beim Loslassen des Betätigungselements 32 durch die Bedienperson in die Aussparung 48 ein, wodurch die Grundplatte 20 bezüglich des Bleches 60 fixiert wird, da ohne Betätigen des Betätigungselements 32 der Vorsprung 68 an die Ränder der Aussparung 48 anstößt, ohne daß sich die Grundplatte 20 und damit auch die Tastatur 12 bewegen.

Die Schrägen 62 und 64 dienen als Bremsvorrichtung, falls beim Bewegen der Grundplatte 20 in die Ruheposition oder in die Bedienposition das Betätigungselement 32 nicht mehr betätigt wird. In diesem Fall wird der Vorsprung 68 durch die Feder 44 wieder in seine Normalstellung gedrückt und kommt beim Erreichen der Bedienposition mit der Schräge 62 und beim Erreichen der Ruheposition mit der Schräge 64 in Berührung. Die Schrägen 62 und 64 zwingen den Vorsprung in Richtung des Pfeils 78 entgegen der Federkraft der Feder 44. Die Feder 44 wirkt mit zunehmender Auslenkung des Vorsprungs 68 als Bremse.

Fig. 2 zeigt in einem Teil b eine Vergrößerung der Auflagefläche 30 gemäß der Schnittdarstellung des Teils a der Fig. 2. Die Auflagefläche 30 ist eine Verlängerung der Bodenplatte 20 und so gebogen, daß ein Hohlraum 90 entsteht, in welchem das Betätigungselement 32 an einem Scharnier 92 befestigt ist, das mit der anderen Scharnierfläche an der Auflagefläche 30 befestigt ist. Somit kann das Betätigungselement 32 in Richtung eines Pfeils 94 durch die Finger 96 einer Bedienperson gedrückt werden. Dabei kann die Außenfläche der Auflagefläche 30 als Gegendruckfläche für einen Daumen 98 der Bedienperson dienen. In Richtung eines Pfeils 100 wird das Betätigungselement 32 durch die Federkraft der Feder 44, die über das Rastelement 34 und den Hebel 36 übertragen wird, gezogen.

Teil c der Fig. 2 zeigt eine Schnittdarstellung der Haltevorrichtung 10 entlang des Schnittes II gemäß Teil a der Fig. 2, welcher quer zur Bewegungsrichtung 28, 30 der Grundplatte 20 liegt. Dabei befindet sich das Rastelement 34 jedoch in einer Position P1 gemäß Teil a der Fig. 2. Zwischen Teleskopschiene 26 und Führungsaufnahme 16 befinden sich Kugeln 110 und 112, welche die Reibung beim Bewegen der Grundplatte 20 herabsetzen.

Das Rastelement 34 ist an einem Bolzen 114 mit Hilfe eines Sicherungsringes 116 befestigt. Der Bolzen 114 ist ortsfest mit dem Winkel 38 verbunden. Ein Bolzen 118 verbindet den Hebel 36 und das Rastelement 34. Dabei hält ein Sicherungsring 120 den Hebel 36 und den Bolzens 118 nahe beieinander, wobei jedoch eine Drehbewegung zwischen Hebel 36 und Rastelement 34 ermöglicht ist.

Figur 3 zeigt in einem Teil a die Anordnung der Haltevorrichtung 10 in dem Drucker 130. Der Drucker 130 hat einen Rahmen 132, an dem die Haltevorrichtung 10 in einem Winkel von etwa 20 Grad zur Horizontalen befestigt ist. Am Rahmen 132 ist außerdem eine vertikal schwenkbare Anzeigeeinheit 134 befestigt, die Betriebszustände des Druckers 130 anzeigt und an der Betätigungselemente 136, z.B. zum Ein- und Ausschalten des Druckers 130, angeordnet sind.

Der Drucker 130 ist durch eine Verkleidung 138 vor Umwelteinflüssen geschützt. Im Bereich der Anzeigeeinheit 134 und der Haltevorrichtung 10 wird die Verkleidung durch ein Tür 140 gebildet, welche ein Fenster 142 für die Anzeigeeinheit 134 hat. Bei verschlossener Tür 140 ist ein Zugriff auf die Tastatur 12 nicht möglich.

Teil b der Figur 3 zeigt den Drucker 130 bei geöffneter Tür 140, welche nur durch eine qualifizierte Person für Servicezwecke geöffnet wird. Für den Service wird auch die Tastatur 12 verwendet, so daß die qualifizierte Bedienperson die Grundplatte 20 nach der oben beschriebenen Art und Weise in die Bedienposition zieht. In der Bedienposition befindet sich die Tastatur 12 unterhalb der Anzeigeeinheit 134 zwischen Bedienperson und Anzeigeeinheit 134, so daß bestimmte Betriebszustände des Druckers 130 über die Tastatur durch Eingabe von Steuerdaten abgefragt werden. Die Anzeigeeinheit 134 zeigt die momentanen Betriebszustände dann an.

Nach Beenden der Servicearbeiten wird die Tastatur 12 wieder in die Ruheposition geschoben. Danach wird die Tür 140 wieder verschlossen, so daß für die Bedienung des Druckers 130 nur noch die Betätigungselemente 136 zugänglich sind.

### Bezugszeichenliste

- 10: Haltevorrichtung
- 12: Tastatur
- 14, 16: Führungsaufnahme
- 18: Verbindungsleitung
- 20: Rundplatte
- 22: Befestigungsblech
- 24, 26: Teleskopschiene
- 28, 29: Pfeil
- 30: Auflagefläche
- 32: Betätigungselement
- 34: Rastelement
- 36: Hebel
- 38: Winkel
- 40: Drehachse
- 42: Hohlniet
- 44: Feder
- 46, 48: Aussparung
- 60: Blech
- 62, 64: Schrägen
- 66: Blech
- 68: Vorsprung
- 69: Pfeil
- 70, 72: Anschlagfläche
- 74, 76: Lager
- 78: Pfeil
- 90: Hohlraum
- 92: Scharnier
- 94: Pfeil
- 96: Finger
- 98: Daumen
- 100: Pfeil
- P1: Position
- 110, 112: Kugel
- 114: Bolzen
- 116: Sicherungsring
- 118: Bolzen
- 120: Sicherungsring
- 130: Drucker
- 132: Rahmen
- 134: Anzeigeeinheit
- 136: Betätigungselement
- 138: Verkleidung
- 140: Tür
- 142: Fenster

## Patentansprüche

1. Vorrichtung (10) zum Halten einer Eingabeeinheit (12) zur Eingabe von Steuerdaten in ein elektrisches gerät, insbesondere in einen Drucker (130) oder Kopierer,
mit mindestens einem an der Eingabeeinheit (12) angeordneten Führungselement (24, 26), das von einem am Gerät (130) angeordneten Aufnahmeelement (14, 16) bewegbar aufgenommen ist,
wobei die Eingabeeinheit (12) im wesentlichen zwischen einer Ruheposition, in welcher die Eingabeeinheit innerhalb des Geräts (130) gelagert ist, und einer Bedienposition bewegbar ist, in welcher die Eingabeeinheit (12) frei von außen betätigbar ist, dadurch **gekennzeichnet**, daß das Aufnahmeelement (14, 16) zur Horizontalen geneigt angeordnet ist und daß das mindestens eine Führungselement (24,26) derart an der Eingabeeinheit angeordnet ist, daß die Eingabeeinheit (12) im wesentlichen in einer zur Horizontalen geneigten Ebene bewegbar ist.

2. Vorrichtung (10) nach Anspruch 1, dadurch **gekennzeichnet**, daß das Führungselement (24) in einem Randbereich der Eingabeeinheit (12) angeordnet ist und daß ein zweites Führungselement (26) an einem dem Randbereich gegenüberliegenden Randbereich der Eingabeeinheit (12) angeordnet ist.

3. Vorrichtung (10) nach Anspruch 1 oder 2, dadurch **gekennzeichnet**, daß in der Bedienposition das dem Gerät (130) abgewandte Ende des Führungselements (24, 26) über das dem Gerät (130) abgewandte Ende des Aufnahmeelements (14, 16) hinausragt, vorzugsweise mindestens um die Länge der Eingabeeinheit (12) in Bewegungsrichtung.

4. Vorrichtung (10) nach einem der vorhergehenden Ansprüche, dadurch **gekennzeichnet**, daß das Führungselement (24, 26) eine Schiene ist, welche von dem Aufnahmeelement (14, 16) zumindest teilweise umfaßt ist,
und/oder daß zwischen Führungselement (24, 26)und Aufnahmeelement (14, 16) Walzkörper (110, 112) angeordnet sind.

5. Vorrichtung (10) nach einem der vorhergehenden Ansprüche, dadurch **gekennzeichnet**, daß in der Ruheposition und/oder der Bedienposition mindestens ein Rastelement (34) die Lage des Führungselements (24, 26) fixiert.

6. Vorrichtung (10) nach Anspruch 5, dadurch **gekennzeichnet**, daß das Rastelement (34) an dem dem Gerät (130) zugewandten Endbereich des Führungselements (24, 26) angeordnet ist,
und daß das Rastelement (34) mit einem Hebel (36) verbunden ist, der nahe der Eingabeeinheit (12) endet.

7. Vorrichtung (10) nach Anspruch 5 oder 6, dadurch **gekennzeichnet**, daß am Rastelement (34) ein Rückstellelement (44) zum selbsttätigen Rückstellen des Rastelements (34) in eine Fixierposition angeordnet ist.

8. Vorrichtung (10) nach einem der vorhergehenden Ansprüche, **gekennzeichnet** durch eine erste Bremsvorrichtung zum Bremsen der Bewegung der Eingabeeinheit (12) in Richtung (29) der Bedienposition und/oder eine zweite Bremsvorrichtung zum Bremsen der Bewegung der Eingabeeinheit (12) in Richtung (28) der Ruheposition.

9. Vorrichtung (10) nach Anspruch 8, dadurch **gekennzeichnet**, daß die Bremsvorrichtung mindestens eine Schräge (62, 64) enthält, die im Bewegungsbereich des Rastelements (34) angeordnet ist.

10. Vorrichtung (10) nach einem der vorhergehenden Ansprüche, dadurch **gekennzeichnet**, daß am Gerät (130) abgewandten Ende des Führungselements (24, 26) quer zur Bewegungsrichtung (28, 29) eine Auflagefläche (30) angeordnet ist.

11. Vorrichtung (10) nach Anspruch 10, dadurch **gekennzeichnet**, daß die Auflagefläche (30) um einen Hohlraum (90) verläuft, in welchem ein Betätigungselement (32) zum Betätigen des Rastelements (34) angeordnet ist.

12. Vorrichtung (10) nach Anspruch 11, dadurch **gekennzeichnet**, daß das Betätigungselement (32) etwa über die gesamte Breite der Eingabeeinheit (12) quer zur Bewegungsrichtung (28, 29) verläuft.

13. Vorrichtung (10) nach Anspruch 11 oder 12, dadurch **gekennzeichnet**, daß das Betätigungselement (32) um eine Achse quer zur Bewegungsrichtung drehbar gelagert ist und mit dem Hebel (36) verbunden ist.

14. Vorrichtung (10) nach einem der vorhergehenden Ansprüche, dadurch **gekennzeichnet**, daß das Aufnahmeelement (14, 16) unterhalb eines Druckerbedienfeldes (136) angeordnet ist.

15. Vorrichtung (10) nach einem der vorhergehenden Ansprüche, dadurch gekennzeichnet, daß in Bewegungsrichtung (28, 29) der Eingabeeinheit (12) in der Ruheposition eine Verschlußvorrichtung (140) angeordnet ist, die ein Bewegen in die Bedienposition verhindert.

## Claims

1. Device (10) for holding an input unit (12) for inputting control data into an electric appliance, in particular into a printer (130) or copier,
having at least one guide element (24, 26) which is arranged on the input unit (12) and is held in a moveable manner by a holding element (14, 16) arranged on the appliance (130),
the input unit (12) being essentially moveable between a rest position, in which the input unit is stored within the appliance (130), and an operating position, in which the input unit (12) can be actuated freely from the outside, characterized in that the holding element (14, 16) is arranged inclined with respect to the horizontal, and in that the at least one guide element (24, 26) is arranged on the input unit in such a manner that the input unit (12) can essentially be moved in a plane which is inclined with respect to the horizontal.

2. Device (10) according to Claim 1, characterized in that the guide element (24) is arranged in one edge region of the input unit (12), and in that a second guide element (26) is arranged on an opposite edge region of the input unit (12).

3. Device (10) according to Claim 1 or 2, characterized in that in the operating position that end of the guide element (24, 26) which faces away from the appliance (130) protrudes over that end of the holding element (14, 16) which faces away from the appliance (130), preferably at least by the length of the input unit (12) in the direction of movement.

4. Device (10) according to one of the preceding claims, characterized in that the guide element (24, 26) is a rail which is at least partially grasped by the holding element (14, 16),
and/or in that rolling bodies (110, 112) are arranged between the guide element (24, 26) and holding element (14, 16).

5. Device (10) according to one of the preceding claims, characterized in that in the rest position and/or in the operating position at least one latching element (34) fixes the position of the guide element (24, 26).

6. Device (10) according to Claim 5, characterized in that the latching element (34) is arranged on that end region of the guide element (24, 26) which faces the appliance (130),
and in that the latching element (34) is connected to a lever (36) which ends in the vicinity of the input unit (12).

7. Device (10) according to Claim 5 or 6, characterized in that a restoring element (44) is arranged on the latching element (34) to automatically restore the latching element (34) to a fixing position.

8. Device (10) according to one of the preceding claims, characterized by a first braking device for retarding the movement of the input unit (12) in the direction (29) of the operating position, and/or by a second braking device for retarding the movement of the input unit (12) in the direction (28) of the rest position.

9. Device (10) according to Claim 8, characterized in that the braking device contains at least one slope (62, 64) which is arranged in the region of movement of the latching element (34).

10. Device (10) according to one of the preceding claims, characterized in that a support surface (30) is arranged transversely with respect to the direction of movement (28, 29) on that end of the guide element (24, 26) which faces away from the appliance (130).

11. Device (10) according to Claim 10, characterized in that the support surface (30) runs around a cavity (90) in which an actuating element (32) for actuating the latching element (34) is arranged.

12. Device (10) according to Claim 11, characterized in that the actuating element (32) runs transversely with respect to the direction of movement (28, 29) approximately over the entire width of the input unit (12).

13. Device (10) according to Claim 11 or 12, characterized in that the actuating element (32) is mounted such that it can rotate transversely with respect to the direction of movement about an axis, and is connected to the lever (36).

14. Device (10) according to one of the preceding claims, characterized in that the holding element (14, 16) is arranged below a printer operating panel (136).

15. Device (10) according to one of the preceding claims, characterized in that in the rest position a closure device (140) is arranged in the direction of movement (28, 29) of the input unit (12), which closure device prevents movement into the operating position.

## Revendications

1. Dispositif (10) pour maintenir une unité d'entrée (12) pour l'entrée de données de commande dans un appareil électrique, en particulier dans un appareil d'impression (130) ou un copieur, comportant au moins un élément de guidage (24,26), agencé au niveau de l'unité d'entrée (12), qui est reçu de façon mobile par un élément de réception (14,16) agencé au niveau de l'appareil (130), l'unité d'entrée (12) étant mobile sensiblement entre une position de repos, dans laquelle l'unité d'entrée est positionnée à l'intérieur de l'appareil (130), et une position de fonctionnement, dans laquelle l'unité d'entrée (12) est manoeuvrable librement par l'extérieur, caractérisé en ce que l'élément de réception (14,16) est agencé obliquement par rapport à l'horizontale, et en ce que l'un au moins des éléments de guidage (24,26) est agencé au niveau de l'unité d'entrée de telle sorte que l'unité d'entrée (12) soit mobile essentiellement dans un plan incliné par rapport à l'horizontale.

2. Dispositif (10) selon la revendication 1, caractérisé en ce que l'élément de guidage (24) est agencé dans une région périphérique de l'unité d'entrée (12), et en ce qu'un second élément de guidage (26) est agencé dans une région périphérique de l'unité d'entrée (12) en regard de la première région périphérique.

3. Dispositif (10) selon la revendication 1 ou 2, caractérisé en ce que, dans la position de fonctionnement, l'extrémité de l'élément de guidage (24,16) qui est du côté de l'appareil (130) fait saillie au-dessus de l'extrémité de l'élément de réception (14,16) qui est du côté de l'appareil (130), de préférence au moins sur la longueur de l'unité d'entrée (12) dans la direction du déplacement.

4. Dispositif (10) selon l'une des revendications précédentes, caractérisé en ce que l'élément de guidage (24,26) est une glissière, laquelle est au moins partiellement contenue dans l'élément de réception (14,16) et/ou en ce que des corps cylindriques (110,112) sont agencés entre l'élément de guidage (24,26) et l'élément de réception (14,16).

5. Dispositif (10) selon l'une des revendications précédentes, caractérisé en ce que, dans la position de repos et/ou dans la position de fonctionnement, au moins un élément d'arrêt (34) fixe la position de l'élément de guidage (24,26).

6. Dispositif (10) selon la revendication 5, caractérisé en ce que l'élément d'arrêt (34) est agencé au niveau de la région d'extrémité de l'élément de guidage (24,26) qui est du côté de l'appareil (130), et en ce que l'élément d'arrêt (34) est relié à un levier (36) qui se termine à proximité de l'unité d'entrée (12).

7. Dispositif (10) selon la revendication 5 ou 6, caractérisé en ce qu'un élément de rappel (44) est agencé au niveau de l'élément d'arrêt pour ramener automatiquement l'élément d'arrêt (34) dans une position de fixation.

8. Dispositif (10) selon l'une des revendications précédentes, caractérisé par un premier dispositif de freinage pour freiner le mouvement de l'unité d'entrée (12) dans le sens (29) de la position de fonctionnement et/ou par un second dispositif de freinage pour freiner le mouvement de l'unité d'entrée (12) dans le sens (28) de la position de repos.

9. Dispositif (10) selon la revendication 8, caractérisé en ce que le dispositif de freinage comporte au moins un élément incliné (62,64) qui est agencé dans la région de mouvement de l'élément d'arrêt (34).

10. Dispositif (10) selon l'une des revendications précédentes, caractérisé en ce qu'une surface d'appui (30) est agencée à l'extrémité de l'élément de guidage (24, 26) qui est du côté de l'appareil (130), transversalement au sens de mouvement (28,29).

11. Dispositif (10) selon la revendication 10, caractérisé en ce que la surface d'appui (30) borde une cavité (90) dans laquelle est agencé un élément d'actionnement (32) pour actionner l'élément d'arrêt (34).

12. Dispositif (10) selon la revendication 11, caractérisé en ce que l'élément d'actionnement (32) s'étend sensiblement sur toute la largeur de l'unité d'entrée (12), transversalement au sens de mouvement (28,29).

13. Dispositif (10) selon la revendication 11 ou 12, caractérisé en ce que l'élément d'actionnement (32) est positionné de façon à pouvoir tourner autour d'un axe transversal au sens de mouvement, et est relié au levier (36).

14. Dispositif (10) selon l'une des revendications précédentes, caractérisé en ce que l'élément de réception (14,16) est agencé en-dessous d'un panneau de commande (136) de l'appareil d'impression.

15. Dispositif (10) selon l'une des revendications précédentes, caractérisé en ce qu'un dispositif de fermeture (140) est agencé dans la position de repos dans le sens de mouvement (28,29) de l'unité d'entrée (12), lequel dispositif de fermeture empêche tout déplacement vers la position de fonctionnement.
